# EUROPEAN PATENT APPLICATION

(11) **EP 4 369 418 A1**
(43) Date of publication of application: **15.05.2024**
(21) Application number: 23205414.8
(22) Date of filing: 24.10.2023
(51) Int. Cl.: H01L 31/0224, H01L 31/05

(54) **A GRID LINE STRUCTURE WITH ANTI-BREAKAGE GLUING INTERCONNECTION, A SOLAR BATTERY AND A GLUING METHOD**

(30) Priority: 24.10.2022 CN 202211303308
(71) Applicant: Trina Solar Co., Ltd, Changzhou, Jiangsu 213031 (CN)
(72) Inventor: GUO, Junpan, Changzhou, 213031 (CN); ZHANG, Shu, Changzhou, 213031 (CN); CHU, Haiyuan, Changzhou, 213031 (CN); WANG, Le, Changzhou, 213031 (CN)
(74) Representative: Nederlandsch Octrooibureau

(57) **Abstract**

The present invention provides a grid line structure with anti-breakage gluing interconnection, a solar battery and a gluing method. The grid line structure comprises: a plurality of fingers, the plurality of fingers extending along a first direction and arranged at intervals along a second direction; a plurality of gluing points, an adhesive applied on at least part of the plurality of gluing points is an insulating glue to form a plurality of insulating gluing points, each insulating gluing point is located between two adjacent fingers, and at least part of the plurality of insulating gluing points are located on the same straight line in the second direction to form a plurality of insulating gluing lines; the plurality of insulating gluing lines include a first insulating gluing line and a second insulating gluing line; wherein, the grid line structure has a busbar and/or the second insulating gluing line at a position adjacent to the first insulating gluing line in the first direction, and the plurality of insulating gluing points in the second insulating gluing line and the plurality of insulating gluing points in the first insulating gluing line are staggered from each other in the first direction. The grid line structure can solve the problem of transmission interruption caused by overflow of insulating glue in batteries without busbar or with busbar, which improves the stability and reliability of solar batteries.

## Description

### Technical Field

The present invention mainly relates to the technical fields of solar batteries, and in particular to a grid line structure with anti-breakage gluing interconnection, a solar battery and a gluing method.

### Background

With the development of high-efficiency battery technology, the amount of silver applied in batteries such as Topcon and HJT has increased significantly. In order to reduce unit consumption, some batteries will adopt a grid-less or no-busbar battery design. In order to achieve welding, glue (insulating glue) is also used between the fingers to bond and fix the welding ribbons, and then the welding ribbons are welded to the battery fingers to form electrical contact. Although compared with the traditional welding of tin-coated ribbons and busbar Pad spot welding, the unit consumption of silver will be reduced, however, after the glue is applied between the fingers, the pressure when placing the welding ribbons and the thixotropy of the glue itself will make the glue overflow to the surroundings. When the glue overflows onto the finger, it will cause a transmission break between the welding ribbons and the fingers, which will bring greater challenges to the overall manufacturing process and also restrict industrial application.

### Summary

The technical problem to be solved by the present invention is to provide grid line structure with anti-breakage gluing interconnection, a solar battery and a gluing method, which can solve the problem of transmission interruption caused by overflow of insulating glue in batteries, which improves the stability and reliability of solar batteries.

In order to solve the above technical problems, the present application provides a grid line structure with anti-breakage gluing interconnection, the grid line structure comprising: a plurality of fingers, the plurality of fingers extending along a first direction and arranged at intervals along a second direction; a plurality of gluing points, an adhesive applied on at least part of the plurality of gluing points is an insulating glue which form a plurality of insulating gluing points, each insulating gluing point is located between two adjacent fingers, and at least part of the plurality of insulating gluing points are located on the same straight line in the second direction which form a plurality of insulating gluing lines, the plurality of insulating gluing lines include a first insulating gluing line and a second insulating gluing line, wherein, the grid line structure has a busbar and/or the second insulating gluing line at a position adjacent to the first insulating gluing line in the first direction, and the plurality of insulating gluing points in the second insulating gluing line and the plurality of insulating gluing points in the first insulating gluing line are staggered from each other in the first direction.

In one embodiment of the present invention, the grid line structure has the second insulating gluing line at the position adjacent to the first insulating gluing line, and two adjacent insulating gluing points in the first insulating gluing line form a first section Z1 of the first insulating gluing line, a second section Z2 of the second insulating gluing line is formed from the first section Z1 extending to the second insulating gluing line along the first direction, wherein, the second section Z2 has one or more insulating gluing points in an interval excluding two end points of the second section Z2, in order to realize that the plurality of insulating gluing points in the second insulating gluing line and the plurality of insulating gluing points in the first insulating gluing line are staggered from each other in the first direction.

In one embodiment of the present invention, there are at least two fingers between any insulating gluing point in the first insulating gluing line and an adjacent insulating gluing point in the second insulating gluing line.

In one embodiment of the present invention, among the plurality of gluing points, the adhesive applied on at least part of the gluing points is conductive glue to form a plurality of conductive gluing points, and each conductive gluing point is located on the finger or between two adjacent fingers, and the plurality of conductive gluing points are located on the same straight line in the second direction to form a plurality of conductive gluing lines, wherein the grid line structure has the conductive gluing lines at a position adjacent to the first insulating gluing line.

In one embodiment of the present invention, any one of the conductive gluing points in the conductive gluing line and an adjacent insulating gluing point located in the first insulating gluing line are located on the same straight line or staggered from each other in the first direction.

In one embodiment of the present invention, the busbar comprises a plurality of connection points.

In one embodiment of the present invention, any one of the connection points on the busbar and the adjacent insulating gluing point on the first insulating gluing line are staggered from each other in the first direction.

Another aspect of the present invention also provides a solar battery, comprising a cell sheet and a plurality of welding ribbons, at least one surface of the cell sheet has a grid line structure according to any one embodiment of the present invention, and at least part of the welding ribbons are welded and fixed to a plurality of fingers along a first insulating gluing line in the grid line structure.

Another aspect of the present invention also provides an anti-breakage gluing method for no-busbar solar batteries, comprising the following steps: configuring a plurality of fingers, the plurality of fingers extending along a first direction and arranged at intervals along a second direction; determining a plurality of gluing points, and applying insulating glue on at least part of the plurality of gluing points to form a plurality of insulating gluing points, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line and a second insulating gluing line, wherein there is a busbar and/or the second insulating gluing line at a position adjacent to the first insulating gluing line in the first direction, and a plurality of insulating gluing points in the second insulating gluing line and a plurality of insulating gluing points in the first insulating gluing line are staggered from each other in the first direction; bonding and fixing a plurality of welding ribbons along the plurality of insulating gluing lines; and welding and fixing the plurality of welding ribbons on the plurality of fingers.

Another aspect of the present invention also provides an anti-breakage gluing method for busbar solar batteries, comprising the following steps: configuring a plurality of fingers, the plurality of fingers extending along a first direction and arranged at intervals along a second direction; determining a plurality of gluing points, and applying insulating glue on at least part of the plurality of gluing points to form a plurality of insulating gluing points, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line, wherein there are busbars at a position adjacent to the first insulating gluing line in the first direction, and a plurality of connecting points in the busbars and a plurality of insulating gluing points in the first insulating gluing line are staggered from each other in the first direction; bonding and fixing a plurality of welding ribbons along the plurality of insulating gluing lines and a plurality of busbars; and welding and fixing the plurality of welding ribbons on the plurality of fingers.

Compared with the prior art, the present invention has the following advantages: by optimizing and adjusting the design of the gluing position, the present invention enables the insulating glue on adjacent gluing lines to be arranged staggered in the extension direction of the fingers, thereby when manufacturing solar batteries, even if the insulating glue overflows onto the fingers, there will be no interruption in the transmission of the fingers; at the same time, the grid lines of the present invention can be used in solar batteries without busbars or batteries with spaced busbars, which can reduce silver paste consumption and improving the stability and reliability of solar batteries while controlling costs.

### Brief Description of the Drawings

The drawings are included to provide a further understanding of the present application, and they are included and constitute a part of the present application, the drawings show the embodiments of the present application, and serving to explain the principles of the present application together with the description. In the drawings:
Fig. 1 is a schematic structural view of a grid line structure used in a solar batteries in the prior art;
Fig. 2 and Fig. 3 are schematic structural view of a grid line structure with anti-breakage gluing interconnection according to an embodiment of the present invention;
Fig. 4 is schematic structural view of a grid line structure with anti-breakage gluing interconnection according to another embodiment of the present invention;
Fig. 5 is schematic structural view of a grid line structure with anti-breakage gluing interconnection according to another embodiment of the present invention;
Fig. 6 is schematic structural view of a grid line structure with anti-breakage gluing interconnection according to another embodiment of the present invention;
Fig. 7 is a schematic flow chart of an anti-breakage gluing method for no-busbar solar batteries according to an embodiment of the present invention;
Fig. 8 is a schematic flow chart of an anti-breakage gluing method for busbar solar batteries according to another embodiment of the present invention; and
Fig. 9 is schematic structural view of a grid line structure with anti-breakage gluing interconnection according to another embodiment of the present invention;

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

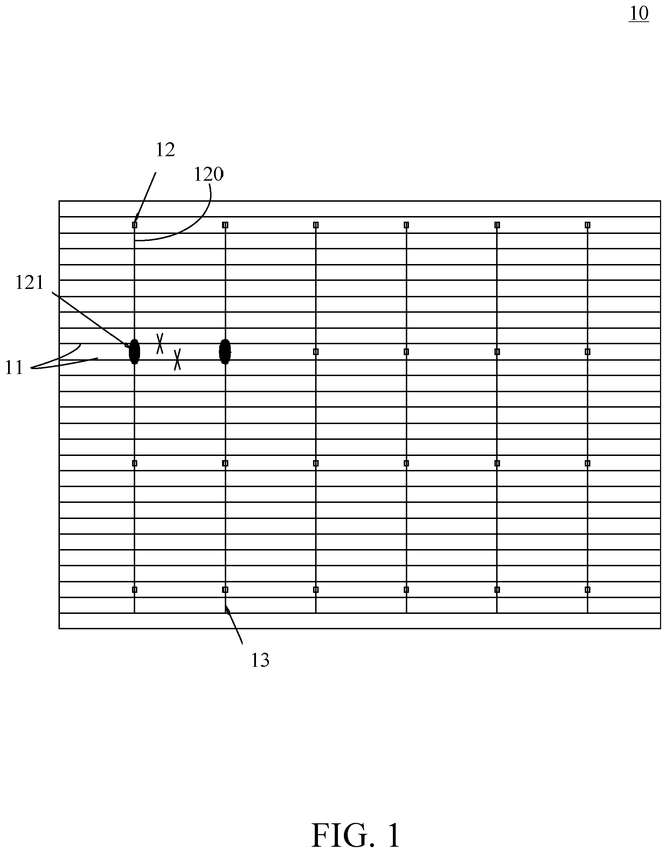

Fig. 1 shows a schematic structural view of a grid line structure used in a solar battery in the prior art. The cell sheet adopts a grid line structure 10 without busbar, and the grid line structure 10 can be arranged on the front and/or back side of the cell sheet. According to Fig. 1, the grid line structure 10 has a plurality of fingers 11, and the glue application method is to apply glue (insulating glue) between the fingers 11. Gluing points 12 on the same straight line is perpendicular to the finger 11 which form a gluing line 120. The tin-coated tape 13 is placed along the position of the gluing line 120 for bonding and fixation, and then the tin-coated tape 13 and the finger 11 are welded to form electrical contact. After placing the tin-coated tape 13, the glue will spread and overflow to the surroundings because of the pressure from the tin-coated tape 13 as well as the thixotropy of the glue itself. For example, at the gluing point 121 shown in Fig. 1, when the insulating glue overflows onto the adjacent fingers 11, it will cause a transmission interruption between the tin-coated tape 13 and the fingers 11.

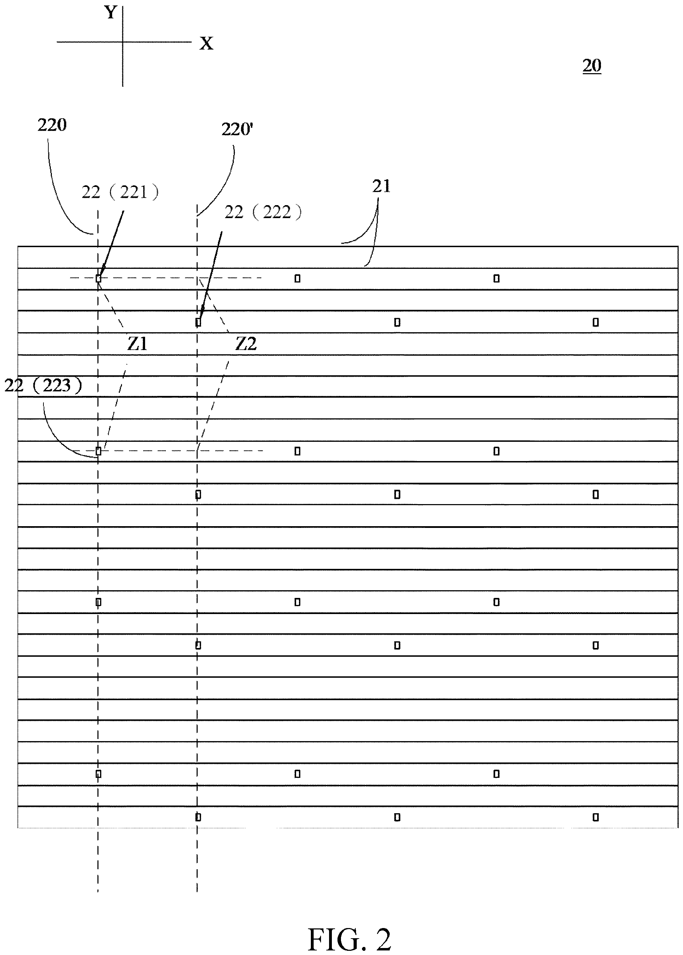

In order to solve such technical problems, the present invention proposes anti-breakage gluing grid line structure 20 with reference to Fig. 2. The grid line structure 20 comprises a plurality of fingers 21 and a plurality of gluing points 22. Wherein, a plurality of fingers 21 extend along the first direction X and are arranged at intervals along the second direction Y. The adhesive applied on the multiple gluing points 22 is insulating glue, thereby forming multiple insulating gluing points 22 in this embodiment. These insulating gluing points 22 are located between two adjacent fingers 21, and since the plurality of insulating gluing points 22 are arranged along the same straight line in the second direction Y, multiple insulating gluing lines 220 can be formed in the grid line structure 20 shown in Fig. 2. Particularly, in the embodiment shown in Fig. 2, the two adjacent insulating gluing lines 220 and the multiple insulating gluing points 22 included in the insulating gluing lines 220' are staggered in the first direction X.

In this embodiment, the insulating gluing line 220 includes multiple insulating gluing points 22. Taking the insulating gluing point 221 as an example, the insulating gluing point 222 and the insulating gluing point 221 are the two adjacent insulating gluing points, that is, the points located on the adjacent insulating gluing lines 220 and 220', and are the closest to each other. As can be seen in Fig. 2, there are two fingers between adjacent insulating gluing points (insulating gluing point 221 and insulating gluing point 222) on adjacent insulating gluing lines 21 in this embodiment. In different embodiments of the present invention, two fingers 21 are used as the lower limit of the distance between adjacent insulating gluing points, in order to better ensure the effect of preventing glue overflow from causing circuit breakage. Therefore, in other embodiments of the present invention, there may be more fingers between adjacent gluing points on adjacent gluing lines. In addition, for the insulating gluing point 222, the adjacent insulating gluing point located in the same insulating gluing line 220 is the insulating gluing point 223, and between the two points there are also multiple fingers.

In this embodiment, the insulating gluing line 220 is defined as the first insulating gluing line, and the gluing line 220' is defined as the second insulating gluing line. The two adjacent insulating gluing points 221 and 223 included in the first insulating gluing line 220 form a first section Z1 of the first insulating gluing line 220; extending from the first section Z1 along the first direction X to the second insulating gluing line 220', it forms a second section Z2 of the second insulating gluing line 220', and there is one insulating gluing point 222 in the interval of the second section Z2 excluding its two end points. In this embodiment, each such second section Z2 has one insulating gluing point in the interval excluding the two end points of the second section Z2, but the present invention is not limited to this. In other embodiments, there may be more insulating gluing points in such second section, thereby ensuring that no circuit breakage caused by glue overflow will occur after gluing in all planes on the front or back of the cell sheet.

It can be understood that Fig. 2 shows an example in which all insulating gluing points 22 are arranged according to the same rule, but the present invention is not limited to the pattern shown in Fig. 2. In some other embodiments of the present invention, the pattern shown in Figure 2 may only provide one area on the surface of the cell sheet, and the fingers in other areas may be arranged with reference to the grid line structure in the prior art. In addition, depending on the material of the glue, in different embodiments of the present invention, only some of the gluing points may be located between the fingers, while other glue points may be located on the fingers due to the conductivity of the applied adhesive. This will be explained in other embodiments below.

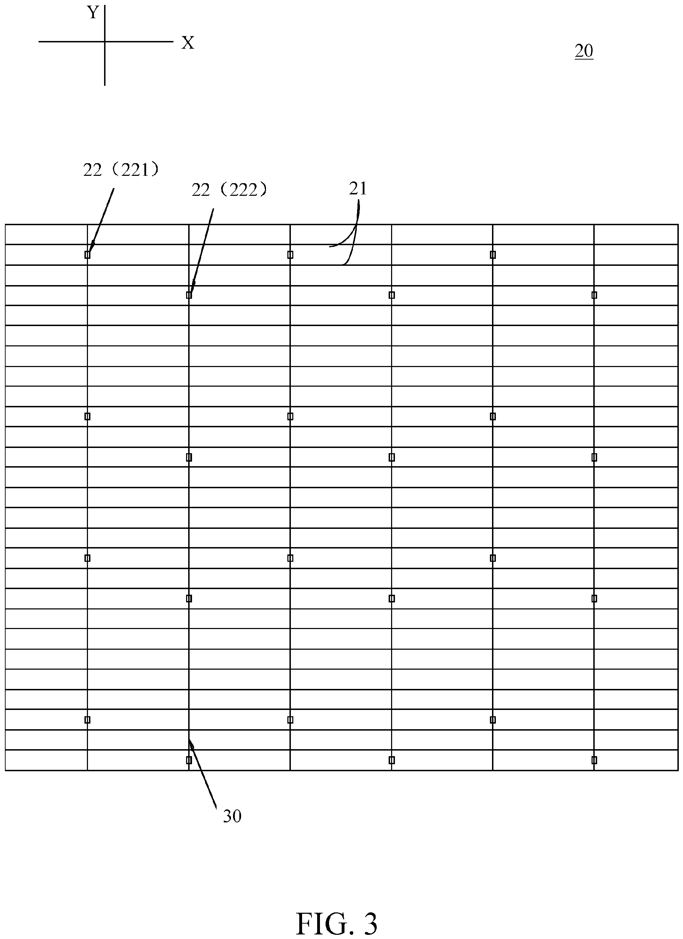

After gluing according to the grid line structure 20 shown in Fig. 2, according to Fig. 3, after bonding and fixing the welding ribbons 30 at the location of each insulating gluing line 220, welding is then performed between the welding ribbons 30 and the plurality of fingers 21. Since the insulating glues are arranged in a staggered manner in the first direction, even if the insulating glue on some gluing points overflows, the fingers on the adjacent areas will continue to maintain the path, thus improving the overall stability and reliability of the solar battery.

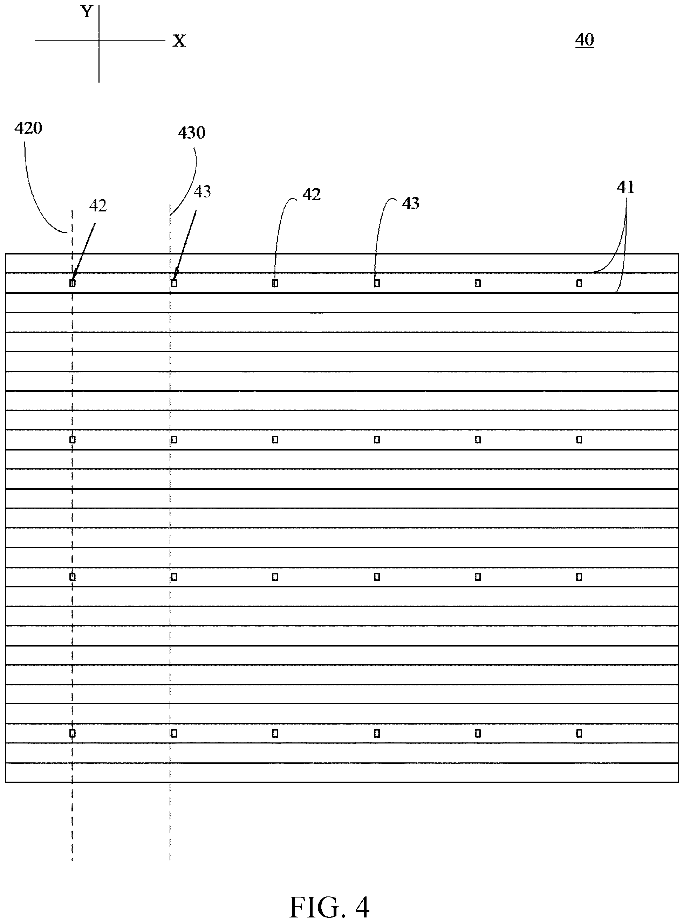

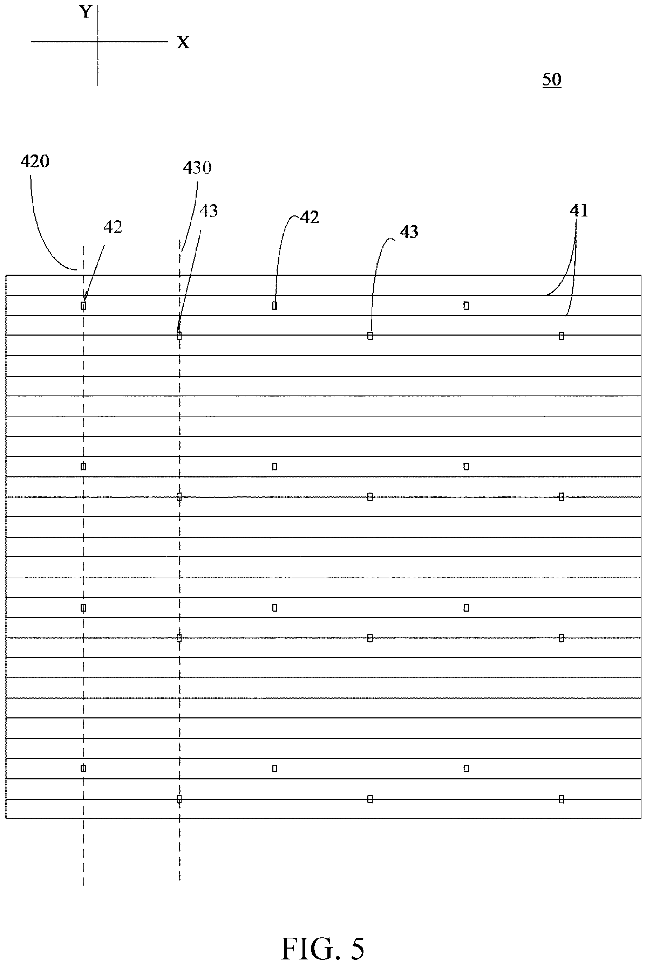

In the embodiment shown in Fig. 2 and Fig. 3, the glue applied on the multiple gluing points 22 is all insulating glue. However, the present invention is not limited to this. In other embodiments of the present invention, conductive glue can also be applied at the location of the gluing points. This method can not only avoid the higher cost problem of placing the conductive glue on all positions, but also provide different matching methods in the design of preventing glue overflow and circuit breakage for batteries with multiple insulating gluing points. Detailed instructions are given below. Fig. 4 and Fig. 5 show examples of two grid line structures 40 and 50 where conductive glue is applied. Fig. 4 and Fig. 5 only differ from each other in the relative positions of some structures, and other features are the same, so the same parts are using same labels.

Referring first to Fig. 4, insulating glue will be applied to the gluing point 42. Therefore, the gluing point 42 is also defined as an insulating gluing point 42 in this embodiment; similarly, the gluing point 43 is a conductive glue point, where conductive glue is applied. In this embodiment, the conductive gluing points 43 are located between the two fingers 41, but the invention is not limited thereto. Since the conductive glue can be conductive itself, the conductive gluing points can also be arranged on the fingers 41, such as the embodiment as shown in Fig. 5.

In addition, in the embodiment shown in Fig. 4 and Fig. 5, since the plurality of insulating gluing points 42 and the plurality of conductive gluing points 43 are respectively arranged along the same straight line in the second direction Y, thereby forming a plurality of insulating gluing lines 420 and a plurality of conductive gluing lines 430. Moreover, the insulating gluing lines 420 and the conductive gluing lines 430 are arranged at intervals in sequence, that is, any insulating gluing line 420 has an adjacent conductive gluing line 430 in the first direction X. In such an embodiment, if the insulating gluing line 420 is defined as the first insulating gluing line in this embodiment, it can also be understood in this embodiment that at the position adjacent to the first insulating gluing line, there is conductive gluing line 430.

In addition, Fig. 4 and Fig. 5 respectively show two different positional relationships between the conductive gluing points 43 and the adjacent insulating gluing points 42. Specifically, in the embodiment shown in Fig. 4, the conductive gluing points 43 and the adjacent insulating glue points 42 are located on the same straight line in the first direction X; while in the embodiment shown in Fig. 5, the conductive gluing points 43 and the adjacent insulating gluing points 42 are staggered from each other in the first direction X. It can be understood that in the above description with reference to Fig. 4 and Fig. 5, when the conductive gluing point 43 and the adjacent insulating gluing point 42 are mentioned, the adjacent insulating gluing point 42 refers to the nearest insulating gluing point 42 located on the insulating gluing line 420 adjacent to the conductive gluing line 430 where the conductive gluing point 43 is located, that is, the conductive gluing points 43 and the insulating gluing points 42 indicated by lines in Fig. 4 and Fig. 5.

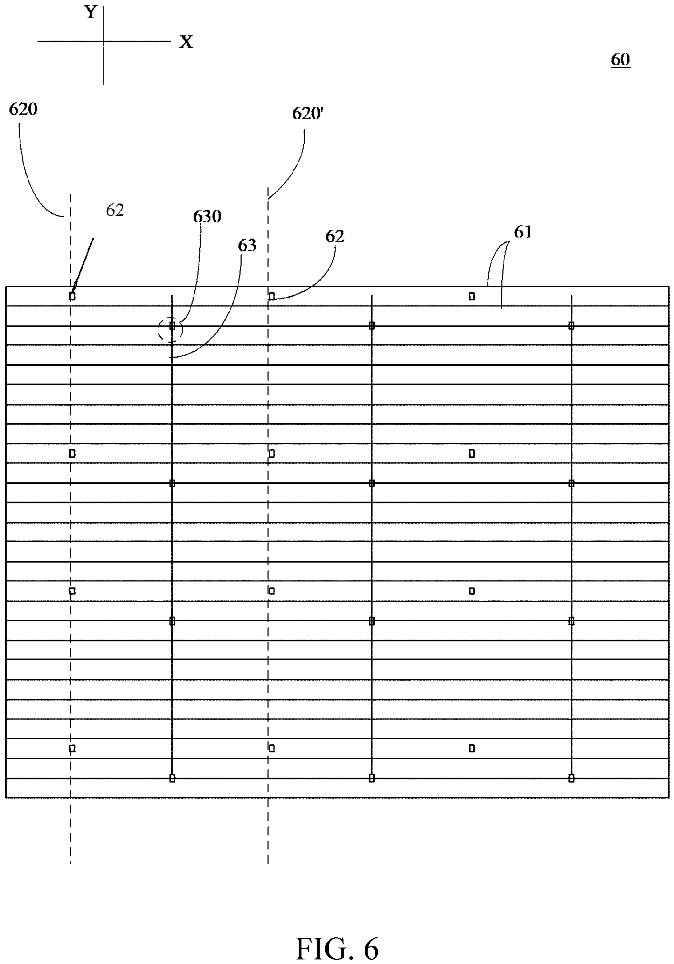

In the embodiments described above with reference to Fig. 2 ~ Fig. 5, each grid line structure adopts a design without busbar. The grid line structure with anti-breakage gluing interconnection proposed by the present invention can also be applied to cell sheet with busbars. Fig. 6 shows one example. According to Fig. 6, the grid line structure 60 includes a plurality of fingers 61, a plurality of gluing points 62 and a plurality of busbars 63. Wherein, the fingers 61 extend along the first direction X and are arranged at intervals along the second direction Y; the busbars 63 extend along the second direction Y and are arranged at intervals along the first direction X. Similar to the previous embodiments, the adhesive applied by the multiple gluing points 62 is insulating glue to form multiple insulating gluing points, and the plurality of insulating glue points 62 are arranged along the same straight line in the second direction Y, thereby forming a plurality of insulating gluing lines 620. In this embodiment, there is one busbar 63 between each two adjacent insulating gluing lines 620 and 620', which means that if the insulating gluing line 620 is defined as the first insulating gluing line in this embodiment, the grid line structure 60 can be understood as having a busbar 63 adjacent to the first insulating gluing line.

Furthermore, there are a plurality of connection points 630 on the busbar 63, which are commonly understood as busbar pad points, for providing welding positions between the welding ribbons and the busbar 63. As can be seen in Fig. 6, the plurality of connection points 630 on the busbar 63 and the plurality of insulating gluing points 62 on the insulating gluing lines 620 are staggered in the first direction X. This means that for any two adjacent insulating gluing lines 620 and 620' and the busbar 63 therein, the insulating gluing points 62 and connection points 630 thereon are not located on the same straight line in the first direction X; surely, considering the plurality of insulating gluing points 62 individually, they can be arranged along the same straight line in the first direction X, as long as it is ensured that the connection point 630 is not located on this straight line, and the technical effect to be achieved by the present invention can be met.

Different embodiments of the grid line structure with anti-breakage gluing interconnection proposed by the present invention have been described above with reference to Fig. 2 ~ Fig. 6. It can be seen that, whether it is a battery without busbars (the embodiment shown in Fig. 2 to Fig. 5) or a battery with busbars (the embodiment shown in Fig. 6), the present invention adopts special design for the location where glue application is required, so that when the gluing point is disconnected due to factors such as glue overflow, a backup path can still maintain conduction around the gluing point. Therefore, the technical solution of the present invention can solve the problem in the existing method of applying insulating glue between finger which is the transmission interruption of the finger caused by the glue overflows onto the finger. On the other hand, even though some embodiments of the present invention use conductive glue, considering that the cost of conductive glue is relatively high, a structural design in the present invention combine insulating glue and conductive glue, and in this way, the amount of conductive glue can be reduced as much as possible in the scheme of applying conductive glue and thus the production cost can be reduced.

Another aspect of the present invention provides a solar battery, which comprises a cell sheet and a plurality of welding ribbons, at least one surface (front/back) of the cell sheet has grid line structure with anti-breakage gluing interconnection proposed by various embodiments of the present invention. During assembly, the welding ribbons can be welded and fixed along the gluing lines in the grid line structure with multiple fingers (for example, refer to the pattern shown in Fig. 3), or in embodiments with busbars, the welding ribbons can be welded on the busbar and the gluing line between two adjacent gluing lines.

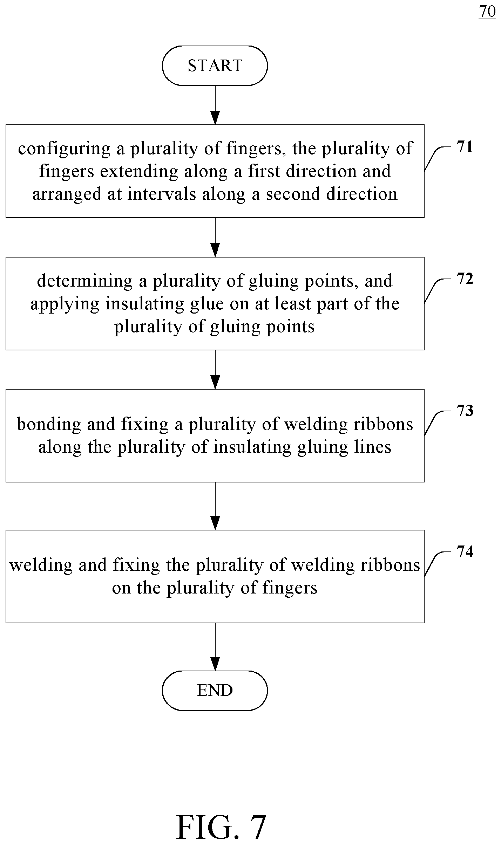

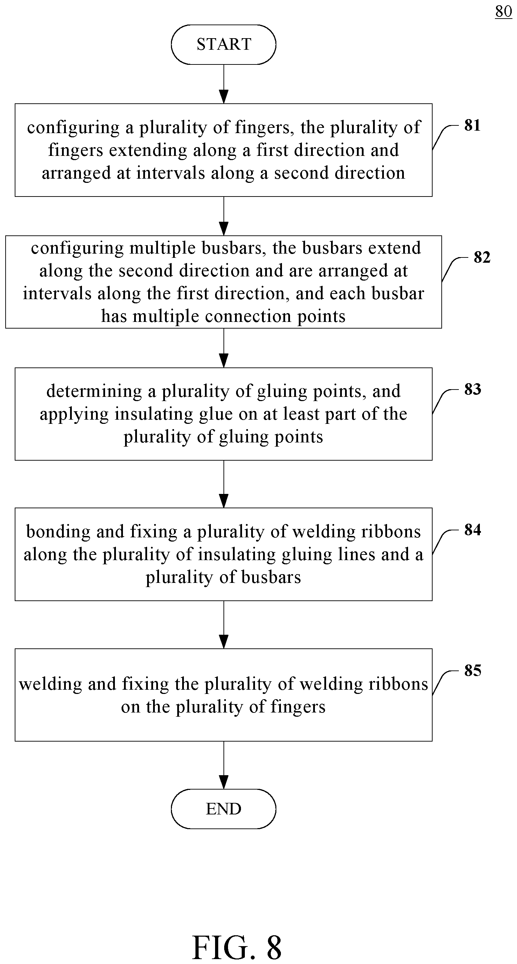

In addition, the present invention also proposes a gluing method 70 and a gluing method 80 for a solar battery respectively with reference to Fig. 7 and Fig. 8, in which the gluing method 70 is for a battery without a busbar, and the gluing method 80 is for a battery with a busbar. The flow chart in Fig. 7 and Fig. 8 are used in this application to illustrate the operations performed by the system according to the embodiment of this application. It should be understood that the preceding or following operations are not necessarily performed in an exact order. Instead, various steps may be processed in reverse order or concurrently. At the same time, other operations can either add to these procedures, or a certain step or steps can be removed from these procedures.

According to Fig. 7, an anti-breakage gluing method 70 for no-busbar solar batteries comprises the following steps:
step 71 is configuring a plurality of fingers, the plurality of fingers extending along a first direction and arranged at intervals along a second direction;
step 72 is determining a plurality of gluing points, and applying insulating glue on at least part of the plurality of gluing points. It is noted that when performing this step, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line and a second insulating gluing line, wherein there is a busbar and/or the second insulating gluing line at a position adjacent to the first insulating gluing line in the first direction, and a plurality of insulating gluing points in the second insulating gluing line and a plurality of insulating gluing points in the first insulating gluing line are staggered from each other in the first direction;
step 73 is bonding and fixing a plurality of welding ribbons along the plurality of insulating gluing lines; and
step 74 is welding and fixing the plurality of welding ribbons on the plurality of fingers.

The gluing method 70 shown in Fig. 7 can be applied to the grid line structures 20-50 shown in Fig. 2 to Fig. 5. For specific details, please refer to the above description. It should be noted that in the above embodiments of the grid line structure, there are also embodiments in which conductive gluing lines are placed adjacent to the insulating gluing lines. In such an embodiment, this can be achieved by slightly adjusting the above process steps, that is, between step 72 and step 73, a step of releasing the conductive glue may be added, and making the conductive gluing points to form conductive gluing lines and be located adjacent to the first insulating gluing lines. For specific details, please refer to the description of the grid line structure above.

According to Fig. 8, an anti-breakage gluing method 70 for busbar solar batteries comprises the following steps:
step 81 is configuring a plurality of fingers, the plurality of fingers extending along a first direction and arranged at intervals along a second direction;
step 82 is configuring multiple busbars, the busbars extend along the second direction and are arranged at intervals along the first direction, and each busbar has multiple connection points;
step 83 is determining a plurality of gluing points, and applying insulating glue on at least part of the plurality of gluing points. It is noted that when performing this step, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line, wherein there are busbars at a position adjacent to the first insulating gluing line in the first direction, and a plurality of insulating gluing points in the busbars and a plurality of insulating gluing points in the first insulating gluing line are staggered from each other in the first direction;
step 84 is bonding and fixing a plurality of welding ribbons along the plurality of insulating gluing lines and a plurality of busbars; and
step 85 is welding and fixing the plurality of welding ribbons on the plurality of fingers.

The gluing method 80 shown in Fig. 8 can be applied to the grid line structure 60 shown in Fig. 6. For specific details, please refer to the above description.

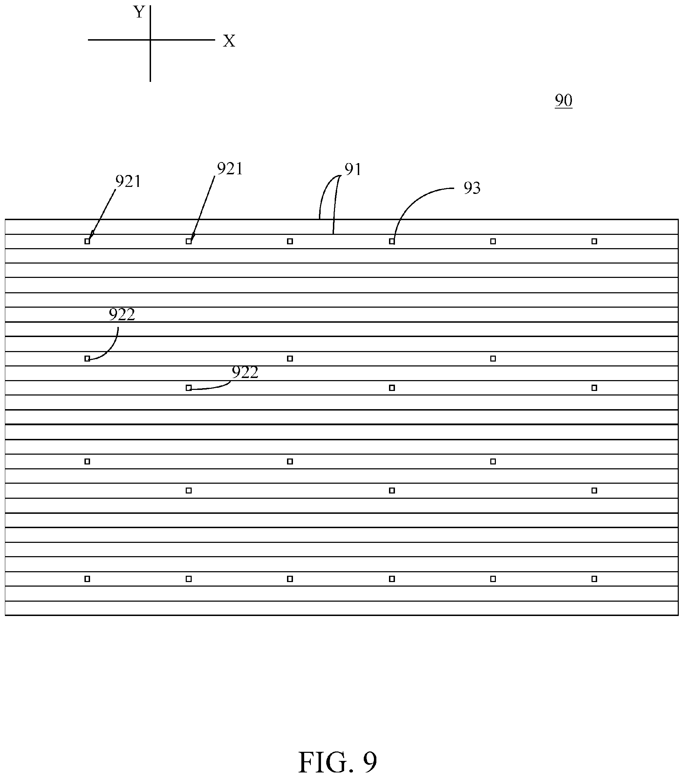

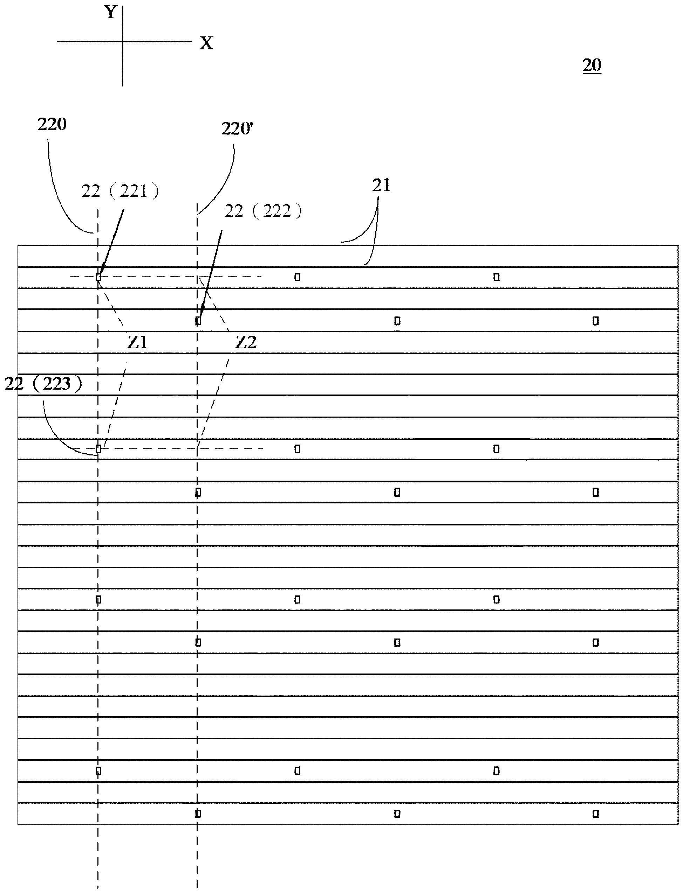

It should be supplemented that, although the anti-breakage grid line structure and gluing method of the present invention during the preparation of batteries can be applied with and without busbars are listed above with reference to Fig. 2 to Fig. 8, each drawing is only a schematic display. In some specific embodiments of the present invention, in practical applications, some grid line structures with anti-breakage gluing interconnection can be combined in the same cell sheet/or battery assembly, or only configuring the grid structure in some embodiments of the present invention in a partial area of a cell sheet, etc. Exemplarily, Fig. 9 shows a grid line structure 90 of the grid line structure with anti-breakage gluing interconnection of the present invention, the grid line structure 90 is designed to be glued to prevent circuit breakage based on a no-busbar battery. In this embodiment, some insulating gluing points 921 may be arranged along the same straight line in the first direction X, while other insulating gluing points 922 may be staggered from each other in the first direction X. Further, some gluing points can also be configured as conductive gluing points 93 with reference to the embodiment shown in Fig. 4. The present invention does not limit the ways in which various grid line structures are combined with each other. Based on the basic structure of the anti-breakage gluing grid line structure proposed in the present invention and the various combined modifications thereof, the circuit breakage of the solar batteries after gluing can be improved and the battery stability can be achieved.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A grid line structure with anti-breakage gluing interconnection, **characterized in that**, the grid line structure comprises:
a plurality of fingers, the plurality of fingers extending along a first direction and arranged at intervals along a second direction;
a plurality of gluing points, an adhesive applied on at least part of the plurality of gluing points is an insulating glue which form a plurality of insulating gluing points, each insulating gluing point is located between two adjacent fingers, and at least part of the plurality of insulating gluing points are located on the same straight line in the second direction which form a plurality of insulating gluing lines, the plurality of insulating gluing lines include a first insulating gluing line and a second insulating gluing line,
wherein, the grid line structure has a busbar and/or the second insulating gluing line at a position adjacent to the first insulating gluing line in the first direction, and the plurality of insulating gluing points in the second insulating gluing line and the plurality of insulating gluing points in the first insulating gluing line are staggered from each other in the first direction.

2. The grid line structure in claim 1, **characterized in that**, the grid line structure has the second insulating gluing line at the position adjacent to the first insulating gluing line, and two adjacent insulating gluing points in the first insulating gluing line form a first section Z1 of the first insulating gluing line, a second section Z2 of the second insulating gluing line is formed from the first section Z1 extending to the second insulating gluing line along the first direction, wherein, the second section Z2 has one or more insulating gluing points in an interval excluding two end points of the second section Z2, in order to realize that the plurality of insulating gluing points in the second insulating gluing line and the plurality of insulating gluing points in the first insulating gluing line are staggered from each other in the first direction.

3. The grid line structure in claim 2, **characterized in that**, there are at least two fingers between any insulating gluing point in the first insulating gluing line and an adjacent insulating gluing point in the second insulating gluing line.

4. The grid line structure in claim 1, **characterized in that**, among the plurality of gluing points, the adhesive applied on at least part of the gluing points is conductive glue to form a plurality of conductive gluing points, and each conductive gluing point is located on the finger or between two adjacent fingers, and the plurality of conductive gluing points are located on the same straight line in the second direction to form a plurality of conductive gluing lines, wherein the grid line structure has the conductive gluing lines at a position adjacent to the first insulating gluing line.

5. The grid line structure in claim 4, **characterized in that**, any one of the conductive gluing points in the conductive gluing line and an adjacent insulating gluing point located in the first insulating gluing line are located on the same straight line or staggered from each other in the first direction.

6. The grid line structure in claim 1, **characterized in that**, the busbar comprises a plurality of connection points.

7. The grid line structure in claim 6, **characterized in that**, any one of the connection points on the busbar and the adjacent insulating gluing point on the first insulating gluing line are staggered from each other in the first direction.

8. A solar battery, **characterized in that**, comprising a cell sheet and a plurality of welding ribbons, at least one surface of the cell sheet has the grid line structure as claimed in any one of the claims 1 to 7, and at least part of the welding ribbons are welded and fixed to a plurality of fingers through a first insulating gluing line in the grid line structure.

9. An anti-breakage gluing method for no-busbar solar batteries, **characterized in that**, the method comprises the following steps:
configuring a plurality of fingers, the plurality of fingers extending along a first direction and arranged at intervals along a second direction;
determining a plurality of gluing points, and applying insulating glue on at least part of the plurality of gluing points to form a plurality of insulating gluing points, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line and a second insulating gluing line, wherein there is a busbar and/or the second insulating gluing line at a position adjacent to the first insulating gluing line in the first direction, and a plurality of insulating gluing points in the second insulating gluing line and a plurality of insulating gluing points in the first insulating gluing line are staggered from each other in the first direction;
bonding and fixing a plurality of welding ribbons along the plurality of insulating gluing lines; and
welding and fixing the plurality of welding ribbons on the plurality of fingers.

10. An anti-breakage gluing method for busbar solar batteries, **characterized in that**, the method comprises the following steps:
configuring a plurality of fingers, the plurality of fingers extending along a first direction and arranged at intervals along a second direction;
configuring multiple busbars, the busbars extending along the second direction and arranged at intervals along the first direction, and each busbar has multiple connection points;
determining a plurality of gluing points, and applying insulating glue on at least part of the plurality of gluing points to form a plurality of insulating gluing points, each insulating gluing point is located between two adjacent fingers, and at least part of the plurality of insulating gluing points are located on the same straight line in the second direction to form a plurality of insulating gluing lines, the plurality of insulated gluing lines include a first insulating gluing line, wherein there are busbars at a position adjacent to the first insulating gluing line in the first direction, and a plurality of connecting points in the busbars and a plurality of insulating gluing points in the first insulating gluing line are staggered from each other in the first direction;
bonding and fixing a plurality of welding ribbons along the plurality of insulating gluing lines and the plurality of busbars; and
welding and fixing the plurality of welding ribbons on the plurality of fingers.
